# EUROPEAN PATENT SPECIFICATION

(11) **EP 3 540 761 B1**
(45) Date of publication and mention of the grant of the patent: **05.01.2022**
(21) Application number: 17869067.3
(22) Date of filing: 06.11.2017
(51) Int. Cl.: H01L 21/304, B24B 37/00, C09G 1/02, C09K 3/14

(54) **POLISHING COMPOSITION AND METHOD FOR POLISHING SILICON WAFER**
POLIERZUSAMMENSETZUNG UND POLIERVERFAHREN FÜR SILICIUMWAFER
COMPOSITION DE POLISSAGE ET PROCÉDÉ DE POLISSAGE DE TRANCHE DE SILICIUM

(30) Priority: 09.11.2016 JP 2016219004
(43) Date of publication of application: 18.09.2019
(73) Proprietor: Fujimi Incorporated, Kiyosu-shi, Aichi 452-8502 (JP)
(72) Inventor: AKIZUKI Reiko, Kiyosu-shi Aichi 452-8502 (JP); TSUCHIYA Kohsuke, Kiyosu-shi Aichi 452-8502 (JP); TANIGUCHI Megumi, Kiyosu-shi Aichi 452-8502 (JP)
(74) Representative: Grünecker Patent- und Rechtsanwälte PartG mbB
(86) International application number: PCT/JP2017/039983
(87) International publication number: WO 2018/088371

(56) References cited:
- WO-A1-2016/060113
- WO-A1-2016/132676
- WO-A1-2016/158324
- US-A1- 2014 302 752
- US-A1- 2016 194 538

## Description

### Technical Field

The present invention relates to a polishing composition and a method for polishing a silicon wafer.

### Background Art

Various technologies on a polishing composition and a polishing method for flattening silicon wafers have been proposed. One of these technologies can be, for example, a technology disclosed in PTL 1. However, in recent years, required quality level of silicon wafers has been getting higher and higher. Thus, these technologies are required to be further improved.

### Citation List

### Patent Literature

PTL 1: JP 2001-011433 A

### Summary of Invention

### Technical Problem

The present invention is intended to solve the problems in the conventional art such as described above and provide a polishing composition and a method for polishing a silicon wafer, capable of providing a high degree of flatness.

### Solution to Problem

The subject matter of the invention is as set out in the appended claims.
In order to achieve the aforementioned object, the polishing composition according to one aspect of the present invention contains abrasives and a basic compound, a product of a non-spherical parameter and a particle diameter distribution width of the abrasives is 4 nm or more and 40 nm or less, the non-spherical parameter of the abrasives is an average value of absolute values |Sr/Si - 1| each obtained by deducting 1 from a ratio Sr/Si of a projected area Sr of each particle constituting the abrasives to a virtual projected area Si of the each particle, the virtual projected area Si is an area of a virtual circle having a vertical Feret's diameter of the each particle as a diameter, and the particle diameter distribution width of the abrasives is a difference between particle diameters at 90% and 10% in a cumulative particle diameter distribution based on a volume of the abrasives. The particle diameters at 90% and 10% are in nm.

The method for polishing a silicon wafer according to another aspect of the present invention includes polishing a silicon wafer using the polishing composition according to the above-described aspect.
Preferred embodiments of the present invention are set forth in the dependent claims.

### Advantageous Effects of Invention

The present invention can provide a high degree of flatness.

### Brief Description of Drawings

FIG. 1 is a drawing explaining a projected area of a particle constituting abrasives.
FIG. 2 is a drawing explaining a virtual projected area of a particle constituting abrasives.
FIG. 3 is another drawing explaining a virtual projected area of a particle constituting abrasives.

### Description of Embodiment

An embodiment of the present invention is described in detail below. A polishing composition according to the present embodiment contains abrasives and a basic compound. As the abrasives, abrasives with the product of a non-spherical parameter and a particle diameter distribution width of 4 nm or more and 40 nm or less is used.

The particle diameter distribution width of the abrasives is a difference between particle diameters at 90% (hereinafter also referred to as "D90") and 10% (hereinafter also referred to as "D10") in a cumulative particle diameter distribution based on the volume of the abrasives. D10 and D90 represent particle diameters at which the cumulative frequency from the small-particle diameter side in the cumulative particle diameter distribution based on the volume become 10% and 90%, respectively. The particle diameters at 90% and 10% are in nm. These D10 and D90 can be measured using a laser diffraction/scattering particle diameter distribution measuring apparatus. As the laser diffraction/scattering particle diameter distribution measuring apparatus, a nanoparticle size distribution measuring apparatus "UPA-UT" available from Nikkiso Co., Ltd. was used.

The non-spherical parameter of the abrasives is an average value of absolute values |Sr/Si - 1| each obtained by deducting 1 from a ratio Sr/Si of a projected area Sr of each particle constituting the abrasives to a virtual projected area Si of the each particle. The virtual projected area Si is an area of a virtual circle having a vertical Feret's diameter of each particle constituting the abrasives as a diameter.

The non-spherical parameter of abrasives is an indicator representing the degree of difference of the shape of each particle constituting the abrasives from the globular shape. The shape of each particle is closer to globular as the non-spherical parameter approaches 0, and the shape of each particle is more different from the globular as the non-spherical parameter is larger. That is, the non-spherical of the shape of each particle is higher as the numerical value of the non-spherical parameter is larger.

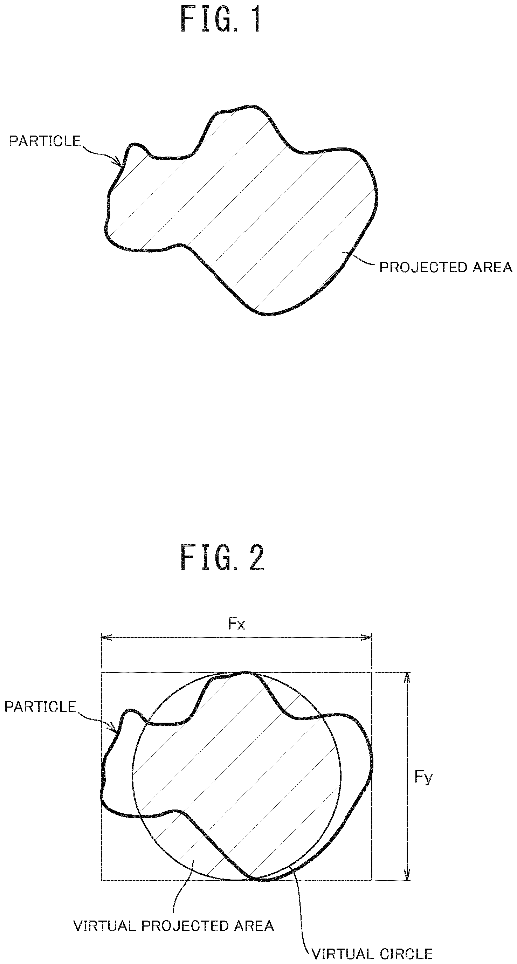

The projected area Sr of each particle constituting the abrasives can be calculated by image analysis using a scanning electron microscope (SEM). The image analysis is described with reference to FIG. 1. The projected area of each particle is obtained from a SEM image. A portion hatched in FIG. 1 is a projected area Sr. Then, a projected area Sr of each particle constituting the abrasives is obtained.

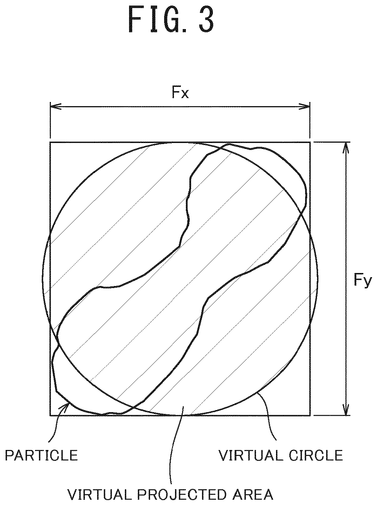

A virtual projected area Si of each particle constituting the abrasives can be calculated by image analysis using a SEM. The image analysis is described with reference to FIGs. 2 and 3. A horizontal Feret's diameter Fx and a vertical Feret's diameter Fy of each particle is obtained from a SEM image. A vertical Feret's diameter Fy of each particle constituting the abrasives is obtained. Then, a virtual projected area Si can be obtained by calculating an area of a virtual circle having this vertical Feret's diameter Fy as a diameter.

The non-spherical parameter of the abrasives is an average value of absolute values |Sr/Si - 1| each obtained by deducting 1 from a ratio Sr/Si of a projected area Sr of each particle constituting the abrasives to a virtual projected area Si of the each particle. The non-spherical parameter of the abrasives was calculated using projected areas Sr and virtual projected areas Si of 200 particles.

Such polishing composition according to the present embodiment can be used suitably for polishing of various polishing objects such as monocrystalline silicon, polycrystalline silicon, silicon compounds, metals, and ceramics, and a high degree of flatness can be provided. Specifically, by using the polishing composition according to the present embodiment to polish a silicon wafer, a silicon wafer such as a silicon single crystal wafer with a high degree of flatness can be produced.

For example, by subjecting a silicon wafer having a hard laser mark formed thereon in production of the silicon wafer to stock polishing, a bump is generated around the hard laser mark in some cases. Accordingly, the flatness of the silicon wafer is reduced. The bump generated around the hard laser mark cannot be removed by final polishing. Thus, the flatness of the completed silicon wafer may be insufficient.

By subjecting the silicon wafer with a hard laser mark formed thereon to stock polishing using the polishing composition according to the present embodiment, generation of a bump around the hard laser mark can be reduced. Therefore, a silicon wafer with a high degree of flatness can be produced by final polishing after stock polishing using the polishing composition according to the present embodiment.

The polishing composition according to the present embodiment is suitable for stock polishing of the silicon wafer with a hard laser mark formed thereon as described above. However, the application of the polishing composition according to the present embodiment and the kind of the polishing object are not particularly limited.

For example, the polishing composition according to the present embodiment can be used for a polishing object with no hard laser mark formed thereon. Moreover, the polishing composition according to the present invention can be used for not only stock polishing, but also final polishing of mirror finishing of the surface of the polishing object after the stock polishing. Further, in the stock polishing of a silicon wafer with a hard laser mark formed thereon, double-sided polishing is generally performed. However, the polishing composition according to the present embodiment can also be used for single-sided polishing.

The polishing composition according to the present embodiment will be described in detail below. The various operations and measurement of various physical properties described below were performed, unless otherwise specified, under the conditions at room temperature of 20°C or more and 25°C or less and a relative humidity of 40% or more and 50% or less.

### 1. With regard to abrasives

In the polishing composition according to the present embodiment, abrasives with the product of a non-spherical parameter and a particle diameter distribution width of 4 nm or more and 40 nm or less is required to be used, and for example, abrasives with the product of a non-spherical parameter and a particle diameter distribution width of 8 nm or more can be used. When abrasives having a high non-spherical of shapes of and a wide particle diameter distribution width of the particles constituting the abrasives are used, the particles constituting the abrasives become less prone to be rolled and are retained in a micro area, and thus, the polishing pressure is increased. Therefore, a high degree of flatness can be provided, and for example, when a silicon wafer with a hard laser mark formed thereon is polished, generation of a bump around the hard laser mark can be reduced.

The product of a non-spherical parameter and a particle diameter distribution width is 40 nm or less, may be 30 nm or less or 20 nm or less. That is, the product of a non-spherical parameter and a particle diameter distribution width is 4 nm or more and 40 nm or less, preferably 4 nm or more and 30 nm or less, more preferably 4 nm or more and 20 nm or less, the most preferably 4 nm or more and 10 nm or less.

The abrasives comprise particles composed of silica, alumina, ceria, and titania; particles composed of silicon nitride, silicon carbide, and boron nitride; polymethyl methacrylate (PMMA) particles; or particles obtained by binding polymethyl methacrylate (PMMA) to silica. Among these particles, silica is preferable, and colloidal silica is more preferable. One kind of abrasives may be used alone, or two or more kinds of abrasives may be used in combination.

An average particle diameter of the abrasives contained in the polishing composition according to the present embodiment is not particularly limited. However, the polishing removal rate is prone to be higher as the average particle diameter is increased. As the average primary particle diameter measured by image observation using SEM, the average primary particle diameter of the abrasives is preferably 20 nm or more, more preferably 30 nm or more, yet more preferably 40 nm or more, yet further more preferably 45 nm or more. As the average secondary particle diameter measured by dynamic light scattering, the average secondary particle diameter of the abrasives is preferably 30 nm or more, more preferably 50 nm or more, yet more preferably 70 nm or more, yet further more preferably 90 nm or more.

From the viewpoint of dispersion stability of the polishing composition, the average primary particle diameter of the abrasives is preferably 500 nm or less, more preferably 200 nm or less, yet more preferably 100 nm or less. Moreover, from the same viewpoint, the average secondary particle diameter of the abrasives is preferably 500 nm or less, more preferably 250 nm or less, yet more preferably 200 nm or less.

The content of the abrasives in the polishing composition according to the present embodiment may be 0.01 mass% or more, preferably 0.1 mass% or more, more preferably 0.3 mass% or more. With the content of the abrasives within the above range, a high degree of flatness can be easily obtained. The content of the abrasives in the polishing composition may be 5 mass% or less, preferably 2 mass% or less, more preferably 1 mass% or less. With the content of the abrasives within the above range, both of a high degree of flatness and a reduction in production cost of the polishing composition can be achieved.

### 2. With regard to basic compound

The polishing composition according to the present embodiment contains a basic compound. This basic compound chemically acts on the surface of a polishing object such as a silicon wafer. The surface of the polishing object is thus chemically polished. By this chemical etching, the polishing removal rate in polishing of the polishing object can be easily improved.

The kind of the basic compound is not particularly limited and can be an organic basic compound or an inorganic basic compound such as alkali metal hydroxide, alkali metal hydrogen carbonate, alkali metal carbonate, and ammonia. One kind of these basic compounds may be used alone, or two or more kinds of these basic compounds may be used in combination.

The kind of the alkali metal hydroxide is not particularly limited, and examples of the alkali metal hydroxide include sodium hydroxide and potassium hydroxide. The kind of the alkali metal hydrogen carbonate is not particularly limited, and examples of the alkali metal hydrogen carbonate include sodium bicarbonate and potassium bicarbonate. The kind of the alkali metal carbonate is not particularly limited, and examples of the alkali metal carbonate include sodium carbonate and potassium carbonate.

The organic basic compound can be, for example, a quaternary ammonium salt such as a tetraalkylammonium salt. An anion in the ammonium salt can be OH⁻. When other basic compounds such as alkali metal hydroxide is used in combination, F⁻, Cl⁻, Br⁻, I⁻, ClO₄⁻, or BH₄⁻ can also be used as an anion. For example, quaternary ammonium salts of choline, tetramethylammonium hydroxide, tetraethylammonium hydroxide, tetrapropylammonium hydroxide, and tetrabutylammonium hydroxide can be favorably used. Among them, tetramethylammonium hydroxide is more preferable.

Another example of the organic basic compound can be a quaternary phosphonium salt such as tetraalkyl phosphonium salt. An anion in the phosphonium salt can be OH⁻. When other basic compounds such as alkali metal hydroxide is used in combination, F⁻, Cl⁻, Br⁻, I⁻, ClO₄⁻, or BH₄⁻ can also be used as an anion. For example, halides and hydroxides of tetramethyl phosphonium, tetraethyl phosphonium, tetrapropyl phosphonium, and tetrabutyl phosphonium can be favorably used, for example.

Other examples of the organic basic compound includes amines, piperazines, azoles, and diazabicycloalkanes, and other cyclic amines and guanidine. Examples of the amines include methylamine, dimethylamine, trimethylamine, ethylamine, diethylamine, triethylamine, ethylenediamine, monoethanolamine, N-(β-aminoethyl)ethanolamine, hexamethylene diamine, diethylenetriamine, and triethylenetetraamine. Examples of the piperazines include piperazine, 1-(2-aminoethyl)piperazine, and N-methylpiperazine. Examples of the azoles include imidazole and triazole. Examples of the diazabicycloalkanes include 1,4-diazabicyclo[2.2.2]octane, 1,8-diazabicyclo[5.4.0]undec-7-ene, and 1,5-diazabicyclo[4.3.0]-5-nonene. Examples of the cyclic amines include piperidine and aminopyridine.

The content of the basic compound in the polishing composition according to the present embodiment may be 0.001 mass% or more, preferably 0.01 mass% or more, more preferably 0.05 mass% or more. With the content of the basic compound within the above range, the polishing removal rate of the polishing object by the polishing composition is improved. The content of the basic compound in the polishing composition may be 5 mass% or less, preferably 3 mass% or less, more preferably 1.5 mass% or less. With the content of the basic compound within the above range, the stability of the polishing composition is increased, and the production cost is reduced.

### 3. With regard to pH of polishing composition

The pH of the polishing composition according to the present embodiment is not particularly limited, and can be 9.0 or more, more preferably 10.0 or more, yet more preferably 10.2 or more. The pH can be 12.0 or less, more preferably 11.4 or less, yet more preferably 11.0 or less. With the pH within the above range, the polishing removal rate is further increased. The pH of the polishing composition can be adjusted by adding a pH adjusting agent to be described below, for example.

### 4. With regard to additive

Various kinds of additives such as a pH adjusting agent, a water-soluble polymer, a surfactant, a chelating agent, and a antifungal agent may be added to the polishing composition according to the present embodiment to improve its performance. Here, the water-soluble polymer may be a water-soluble copolymer or a salt or a derivative of the water-soluble polymer or the water-soluble copolymer. It is preferred that the polishing composition according to the present embodiment does not substantially contain an oxidant.

### 4-1 With regard to pH adjusting agent

The pH of the polishing composition according to the present embodiment can be adjusted by adding a pH adjusting agent. The polishing removal rate of the polishing object, dispersion stability of the abrasives, and the like can be controlled by adjusting the pH of the polishing composition. The amount of the pH adjusting agent to be added is not particularly limited and may be adjusted to a desired pH of the polishing composition.

Specific examples of the pH adjusting agent include inorganic acids, carboxylic acids, and organic acids such as organic sulfuric acid. Specific examples of the inorganic acids include hydrochloric acid, sulfuric acid, nitric acid, hydrofluoric acid, boric acid, carbonic acid, hypophosphoric acid, phosphorous acid, and phosphoric acid. Specific examples of the carboxylic acids include formic acid, acetic acid, propionic acid, butyric acid, valeric acid, 2-methyl butyric acid, n-hexanoic acid, 3,3-dimethyl butyric acid, 2-ethyl butyric acid, 4-methyl pentanoic acid, n-heptanoic acid, 2-methyl hexanoic acid, n-octanoic acid, 2-ethyl hexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, diglycol acid, 2-furancarboxylic acid, 2,5-furandicarboxylic acid, 3-furancarboxylic acid, 2-tetrahydrofuran carboxylic acid, methoxyacetic acid, methoxyphenyl acetic acid, and phenoxyacetic acid. Specific examples of the organic acids include methanesulfonic acid, ethanesulfonic acid, and isethion. One kind of these acids may be used alone, or two or more kinds of these acids may be used in combination.

4-2 With regard to water-soluble polymer

A water-soluble polymer that acts on the surface of the polishing object and the surfaces of the abrasives may be added to the polishing composition according to the present embodiment. Here, the water-soluble polymer may be a water-soluble copolymer or a salt or a derivative of the water-soluble polymer or the water-soluble copolymer. Specific examples of the water-soluble polymer, the water-soluble copolymer, and a salt or a derivative of the water-soluble polymer or the water-soluble copolymer include polycarboxylic acids such as polyacrylic acid and polysulfonic acids such as polyphosphonic acid and polystyrene sulfonic acid. Other specific examples of the same include xanthan gum, polysaccharides such as sodium alginate, cellulose derivatives such as hydroxyethyl cellulose and carboxymethyl cellulose.

Yet other specific examples of the same include a water-soluble polymers having a pyrrolidone unit, polyethylene glycol, polyvinyl alcohol, sorbitan monooleate, and an oxyalkylene-based copolymers having one or more kinds of oxyalkylene units. Examples of the water-soluble polymer having a pyrrolidone unit include polyvinylpyrrolidone, a polyvinylpyrrolidone-polyacrylic acid copolymer, and polyvinylpyrrolidone-vinyl acetate copolymer. Among these water-soluble polymers, a water-soluble polymer having a pyrrolidone unit is preferable, and polyvinylpyrrolidone is more preferable. One kind of these water-soluble polymers may be used alone, or two or more kinds of these water-soluble polymers may be used in combination.

### 4-3 With regard to surfactant

A surfactant may be added to the polishing composition according to the present embodiment. Examples of the surfactant include anionic surfactants and nonionic surfactants. Among these surfactants, nonionic surfactants are favorably used.

Specific examples of the nonionic surfactants include a homopolymer of oxyalkylene, a copolymer of a plurality of kinds of oxyalkylenes, and a polyoxyalkylene adduct. Among these nonionic surfactants, using the copolymer of a plurality of kinds of oxyalkylenes, or the polyoxyalkylene adduct is preferable.

### 4-4 With regard to chelating agent

A chelating agent may be added to the polishing composition according to the present embodiment. The chelating agent captures metal impurity components in a polishing system and forms complexes with the metal impurity components. Thus, metallic contamination of silicon wafers can be inhibited, specifically contamination with nickel and copper.

Specific examples of the chelating agent include: carboxylic acid chelating agents such as gluconic acid; amine chelating agents such as ethylenediamine, diethylenetriamine, and trimethyltetraamine; polyamino polycarboxylic acid chelating agents such as ethylenediaminetetraacetic acid, nitrilotriacetic acid, hydroxyethyl ethylenediaminetriacetic acid, triethylenetetraaminehexaacetic acid; and diethylenetriaminepentaacetic acid; organophosphonate chelating agents such as 2-amino phosphate, 1-hydroxyethylidene-1,1-diphosphate, aminotori(methylene phosphate), ethylenediaminetetrakis(methylene phosphate), diethylenetriaminepenta(methylene phosphate), ethane-1,1-diphosphate, ethane-1,1,2-triphsophate, methane hydroxyphosphate, 1-phosphonobutane-2,3,4-tricarboxylate; phenol derivatives; and 1,3-diketone. Among these chelating agents, using organophosphate chelating agents, specifically ethylenediaminetetrakis(methylene phosphate) is preferable. One kind of these chelating agents may be used alone, or two or more kinds of these chelating agents may be used in combination.

### 4-5 With regard to antifungal agent

A antifungal agent may be added to the polishing composition according to the present embodiment. Specific examples of the antifungal agent include oxazolidine such as oxazolidine-2,5-dione.

### 4-6 With regard to oxidant

It is preferred that the polishing composition according to the present embodiment is substantially free of oxidant. This is because when the polishing composition contains an oxidant, the surface of a polishing object is oxidized through supplying the polishing composition to the polishing object, and an oxide film is generated, and the polishing time is thus increased. Specific examples of the oxidant include hydrogen peroxide (H₂O₂), sodium persulfate, ammonium persulfate, potassium permanganate, and sodium dichloroisocyanurate.

"The polishing composition substantially being free of oxidant" means that an oxidant is not contained at least intentionally. Thus, a polishing composition inevitably containing a trace amount of oxidant derived from raw materials and a production method may be encompassed in the concept of the "polishing composition substantially being free of oxidant" described herein. The concentration of the oxidant in the polishing composition by mole is, for example, 0.0005 mol/L or less, preferably 0.0001 mol/L or less, more preferably 0.00001 mol/L or less, particularly preferably 0.000001 mol/L or less.

### 5. With regard to water

The polishing composition according to the present embodiment may contain water. Water serves as a dispersion medium or solvent for dispersing or dissolving components of the polishing composition, i.e., abrasives, a basic compound, additives, and the like. In order to avoid inhibition of the actions of other components contained in the polishing composition as much as possible, water with 100 ppb or less of a total content of transition metal ions is preferably used, for example. For example, the purity of water can be increased by operations such as removal of impurity ions using an ion-exchange resin, removal of particles by a filter, and distillation. Specifically, ion-exchange water, pure water, ultrapure water, distilled water, and the like are preferably used as water.

### 6. With regard to method for producing polishing composition

A method for producing a polishing composition according to the present embodiment is not particularly limited, and the polishing composition can be produced by stirring and mixing abrasives and a basic compound and various additives such as a pH adjusting agent and a water-soluble polymer as desired. The temperature in the mixing is not particularly limited and is preferably 10°C or more and 40°C or less, and heating may be performed to improve the dissolution rate. The mixing time also is not particularly limited.

### 7. With regard to method for polishing polishing object such as silicon wafer

The polishing of a polishing object using the polishing composition according to the present embodiment can be performed by a general-purpose polishing machine under general-purpose polishing conditions. For example, a single-sided polishing machine and a double-sided polishing machine can be used.

For example, when a wafer such as a silicon wafer as a polishing object is polished using a single-sided polishing machine, the wafer is held using a holding tool called a carrier and is polished by rotating a platen to which a polishing pad has been adhered while pressing one surface of the wafer against the platen and supplying the polishing composition.

When a wafer is polished using a double-sided polishing machine, the wafer is held using a holding tool called a carrier and is polished by rotating platens to which a polishing pad has been adhered on both sides of the wafer while pressing the platens against both surfaces of the wafer from the both sides and supplying the polishing composition.

With either of the polishing machines, a wafer is polished by physical action caused by friction between the polishing pad and the polishing composition and chemical action of the polishing composition on the wafer.

As the polishing pad, polishing pad made of various materials such as polyurethane, nonwoven fabric, and suede can be used. In addition to the polishing pads made of various materials, polishing pads having different physical properties such as the hardness and the thickness can be used. Further, both of a polishing pad containing abrasives and a polishing pad being free of abrasives can be used. The polishing pad being free of abrasives is preferably used. Moreover, a polishing pad with a groove for retaining a liquid polishing composition can also be used.

Among the polishing conditions, a polishing pressure which is a load pressure on the polishing object is not particularly limited and may be 5 kPa or more and 50 kPa or less, preferably 8 kPa or more and 40 kPa or less, more preferably 10 kPa or more and 30 kPa or less. With the polishing pressure within this range, a sufficient polishing removal rate can be exhibited, and breakage of the polishing object and a defect(s) such as scratches on the surface of the polishing object, generated by the pressure can be inhibited.

Among the polishing conditions, a relative velocity (linear velocity) between a polishing pad to be used in polishing and a polishing object such as a silicon wafer is not particularly limited and may be 10 m/min or more and 300 m/min or less, preferably 30 m/min or more and 200 m/min or less. With the relative velocity between the polishing pad and the polishing object within this range, a sufficient polishing removal rate can be obtained. Moreover, breakage of the polishing pad generated by friction of the polishing object can be prevented. Further, friction is sufficiently transmitted to the polishing object, i.e., the state of sliding of the polishing object can be inhibited. Thus, sufficient polishing can be performed.

Among the polishing conditions, the supplying amount of the polishing composition may be an amount sufficient to uniformly supply the polishing composition to the entire surface between the polishing object and the polishing pad although it differs depending on the kinds of the polishing object and the polishing machine and the polishing conditions. With a small supplying amount of the polishing composition, the polishing composition may not be supplied to the entire polishing object, and a defect(s) due to drying and hardening of the polishing composition is generated on the surface of the polishing object. In contrast, with a large supplying amount of the polishing composition, it is economically insufficient, and polishing may be inhibited through inhibiting friction by an excess amount of the polishing composition. Specifically, polishing is inhibited through inhibiting friction by water.

The polishing composition according to the present embodiment can be recovered after using it for polishing of a polishing object and reused for polishing of another polishing object. An example of a method for reusing the polishing composition can be a method wherein the polishing composition discharged from the polishing machine is recovered in a tank, then again circulated into the polishing machine, and used for another polishing. When the polishing composition is used in recycle, the amount of the polishing composition discharged as a waste fluid can be reduced, and an environmental stress thus can be reduced. In addition, the amount of the polishing composition to be used can be reduced, and the production cost required for polishing of a polishing object thus can be reduced.

When the polishing composition according to the polishing composition is reused, the polishing composition is reused preferably after partially or entirely adding, as a composition adjusting agent, the amounts of abrasives, a basic compound, additives, and the like consumed or lost by the use of them in polishing. As the composition adjusting agent, a mixture obtained by mixing abrasives, a basic compound, additives, and the like at any mixing ratio can be used. By additionally adding the composition adjusting agent, composition of the polishing composition is adjusted to composition desired to reuse it, and desired polishing can be performed. The concentrations of abrasives, a basic compound, and other additives contained in the composition adjusting agent are any concentrations, not particularly limited, and may be adjusted, as appropriate, according to the size of the tank and the polishing conditions.

The present embodiment merely shows an example of the present invention, and the present invention is not limited to present embodiment. Various variations and modifications can be made to the present embodiment. For example, the polishing composition according to the present embodiment may be of one-agent type or multi-agent type such as two-agent type obtained by mixing components of the polishing composition partially or entirely at any ratio. When a polishing object is polished, the polishing may be performed using a concentrated liquid of the polishing composition according to the present embodiment as it is. However, a dilution of the polishing composition obtained by diluting the concentrated liquid by 10 times or more with a diluent such as water may also be used.

### [Examples]

The following shows examples, and the present invention will be described in further detail below with reference to Table 1.

Polishing compositions of Examples 1 to 7 and Comparative Examples 1 to 4 were produced by mixing abrasives composed of colloidal silica, three kinds of basic compounds, an additive, and ultrapure water. The three kinds of basic compounds were potassium hydroxide, potassium carbonate, and tetramethylammonium hydroxide, and the additive was a chelating agent.

All of the polishing compositions were produced by diluting a concentrated liquid by 30 times with ultrapure water. In the concentrated liquid, the concentration of colloidal silica was 11.7 mass%, the concentration of potassium hydroxide was 0.13 mass%, the concentration of potassium carbonate was 1.12 mass%, the concentration of tetramethylammonium hydroxide was 1.72 mass%, and the concentration of ethylenediaminetetrakis(methylene phosphate), which is a chelating agent, was 0.08 mass%.

The difference among the polishing compositions of Examples 1 to 7 and Comparative Examples 1 to 4 is only the kind of colloidal silica. Table 1 summarizes non-spherical parameter and the particle diameter distribution widths (D90 to D10) of each colloidal silica used in each of the polishing compositions of Examples 1 to 7 and Comparative Examples 1 to 4 and the product of the non-spherical parameter and the particle diameter distribution width. Table 1 also summarizes D10, D90, and an average particle diameter D50 of each colloidal silica used in each of the polishing compositions of Examples 1 to 7 and Comparative Examples 1 to 4.

The non-spherical parameter of each colloidal silica was calculated from image analysis using SEM. D10 and D90 of each colloidal silica was measured using a nanoparticle size distribution measuring apparatus "UPA-UT" available from Nikkiso Co., Ltd.

**[Table 1]**

| | Non-spherical parameter | Particle diameter | | | Particle diameter distribution width (nm) | Product of non-spherical parameter and particle diameter distribution width | Polishing performance | |
|---|---|---|---|---|---|---|---|---|
| | | D10 (nm) | D90 (nm) | D50 (nm) | | | Polishing removal rate (µm/min) | Height of bump (µm) |
| Ex. 1 | 0.11 | 55.6 | 137.2 | 87.4 | 81.6 | 8.6 | 0.23 | 0.035 |
| Ex. 2 | 0.50 | 20.0 | 58.4 | 30.3 | 38.4 | 19.2 | 0.19 | 0.077 |
| Ex. 3 | 0.51 | 30.5 | 99.5 | 46.6 | 69.0 | 35.5 | 0.20 | 0.028 |
| Ex. 4 | 0.10 | 54.0 | 98.6 | 73.5 | 44.6 | 4.5 | 0.23 | 0.010 |
| Ex. 5 | 0.20 | 75.3 | 128.7 | 99.2 | 53.4 | 10.7 | 0.23 | 0.107 |
| Ex. 6 | 0.11 | 82.2 | 163.1 | 115.0 | 80.9 | 8.9 | 0.23 | 0.035 |
| Ex. 7 | 0.10 | 73.9 | 189.5 | 117.0 | 115.6 | 11.6 | 0.22 | 0.035 |
| Comp. Ex. 1 | 0.10 | 12.7 | 23.3 | 17.1 | 10.6 | 1.1 | 0.00 | Unmeasurable |
| Comp. Ex. 2 | 0.07 | 21.4 | 36.6 | 27.9 | 15.2 | 1.1 | 0.21 | 0.377 |
| Comp. Ex. 3 | 0.10 | 36.4 | 60.1 | 46.2 | 23.7 | 2.3 | 0.23 | 0.386 |
| Comp. Ex. 4 | 0.14 | 15.3 | 26.2 | 20.0 | 10.9 | 1.5 | 0.00 | Unmeasurable |

Bare silicon wafers with a diameter of 4 inch were polished using the polishing compositions of Examples 1 to 7 and Comparative Examples 1 to 4, respectively, under the following polishing conditions. A hard laser mark was formed on the surface of each bare silicon wafer. A conductivity type of each bare silicon wafer was p type, and each bare silicon wafer had crystal orientation <100> and a resistivity of 0.1 Ω·cm or more and less than 100 Ω·cm.

### (Polishing conditions)

Polishing machine: Single-sided polishing machine, model "EJ-380IN", available from Engis Japan Corporation Polishing pad: "MH-S15A" available from Nitta Haas Incorporated
Polishing pressure: 16.7 kPa
Rotational speed of the platen: 50 min⁻¹
Rotational speed of the head (carrier): 40 min⁻¹
Polishing time: time until the polishing removal becomes 5 µm (provided that the polishing is finished in 60 min when the polishing removal does not reach 5 µm)
Supply flow rate of the polishing composition: 100 mL/min (one way use)
Temperature of the polishing composition: 23°C to 26°C

The masses of each bare silicon wafer before and after the polishing were measured, and a polishing removal rate was calculated from the difference between the masses, the polishing time, an area of a polishing surface, the density of silicon, and the like. Table 1 summarizes the results obtained.

Moreover, the surface of each bare silicon wafer after the polishing was analyzed, and the height of a bump generated around the hard laser mark was measured. Table 1 summarizes the results obtained. The height of the bump was measured using a contour measuring device, SURFCOM DX-12 available from Tokyo Seimitsu Co., Ltd.

As can be seen from Table 1, in the polishing compositions of Examples 1 to 7, the product of the non-spherical parameter and the particle diameter distribution width of each colloidal silica was 4 or more, and thus, the polishing removal rate was high, and the height of the bump generated around each hard laser mark was low. These results demonstrate that by polishing the surface of a silicon wafer with a hard laser mark formed thereon using the polishing compositions of Examples 1 to 7, generation of a bump around the hard laser mark can be reduced.

In contrast, in the polishing compositions of Comparative Examples 1 to 4, the product of the non-spherical parameter and the particle diameter distribution width of each colloidal silica was less than 4, and thus, the height of the bump generated around each hard laser mark was high. These results demonstrate that even by polishing the surface of a silicon wafer with a hard laser mark formed thereon using the polishing compositions of Comparative Examples 1 to 4, generation of a bump around the hard laser mark cannot be sufficiently reduced. Specifically, the surface of the bare silicon wafer could not be polished using each of the polishing compositions of Comparative Examples 1 and 4.

### Reference Signs List

- Fx: horizontal Feret's diameter
- Fy: vertical Feret's diameter

## Claims

1. A polishing composition comprising one or more kinds of abrasives and a basic compound, wherein a product of a non-spherical parameter and a particle diameter distribution width of the abrasives is 4 nm or more and 40 nm or less determined as described in the description,
the non-spherical parameter of the abrasives is an average value of absolute values |Sr/Si - 1| each obtained by deducting 1 from a ratio Sr/Si of a projected area Sr of each particle constituting the abrasives to a virtual projected area Si of the each particle,
the virtual projected area Si is an area of a virtual circle having a vertical Feret's diameter of the each particle as a diameter, and
the particle diameter distribution width of the abrasives is a difference between particle diameters at 90% and 10% in a cumulative particle diameter distribution based on a volume of the abrasives,
wherein the abrasives comprise particles composed of silica, alumina, ceria, titania, silicon nitride, silicon carbide, boron nitride or polymethyl methacrylate (PMMA), or particles obtained by binding polymethyl methacrylate (PMMA) to silica.

2. The polishing composition according to claim 1, wherein the abrasives comprise silica.

3. The polishing composition according to claim 1 or 2, for polishing a silicon wafer.

4. A method for polishing a silicon wafer, comprising polishing a silicon wafer using the polishing composition according to any one of claims 1 to 3.

## Patentansprüche

1. Polierzusammensetzung, umfassend eine oder mehrere Arten von Schleifmitteln und eine basische Verbindung , wobei ein Produkt aus einem nichtsphärischen Parameter und einer Partikeldurchmesserverteilungsbreite der Schleifmittel 4 nm oder mehr und 40 nm oder weniger ist, bestimmt wie in der Beschreibung beschrieben,
wobei der nichtsphärische Parameter der Schleifmittel ein Mittelwert der absoluten Werte |Sr/Si - 1| ist, die jeweils durch Abziehen von 1 von einem Verhältnis Sr/Si einer projizierten Fläche Sr jedes die Schleifmittel bildenden Partikel zu einer virtuellen projizierten Fläche Si jedes Partikels erhalten werden,
wobei die virtuelle projizierte Fläche Si eine Fläche eines virtuellen Kreises ist, besitzend einen vertikalen Feret-Durchmesser des jeweiligen Partikels als Durchmesser, und
wobei die Partikeldurchmesserverteilungsbreite der Schleifmittel eine Differenz zwischen den Partikeldurchmessern bei 90 % und 10 % in einer kumulativen Partikeldurchmesserverteilung ist, bezogen auf ein Volumen der Schleifmittel,
wobei die Schleifmittel aus Siliziumdioxid, Aluminiumoxid, Ceroxid, Titandioxid, Siliziumnitrid, Siliziumcarbid, Bornitrid oder Polymethylmethacrylat (PMMA) oder Partikeln, erhalten durch Bindung von Polymethylmethacrylat (PMMA) an Siliziumdioxid, zusammengesetzt sind.

2. Die Polierzusammensetzung nach Anspruch 1, wobei die Schleifmittel Siliziumdioxid umfassen.

3. Die Polierzusammensetzung nach Anspruch 1 oder 2 zum Polieren eines Siliziumwafers.

4. Verfahren zum Polieren eines Siliziumwafers, umfassend das Polieren eines Siliziumwafers unter Verwenden der Polierzusammensetzung nach irgendeinem der Ansprüche 1 bis 3.

## Revendications

1. Composition de polissage comprenant un ou plusieurs types d'abrasifs et un composé de base, dans laquelle un produit présente un paramètre non sphérique et une largeur de distribution des diamètres de particule des abrasifs supérieure ou égale à 4 nm et inférieure ou égale à 40 nm, tel que déterminé dans la description,
le paramètre non sphérique des abrasifs est une valeur moyenne des valeurs absolues |Sr/Si - 1| obtenues chacune en soustrayant 1 du ratio Sr/Si de la surface projetée Sr de chaque particule constituant les abrasifs par la surface projetée virtuelle Si de chaque particule,
la surface projetée virtuelle Si est la surface d'un cercle virtuel ayant un diamètre de Feret vertical de chaque particule comme diamètre, et
la largeur de distribution des diamètres de particule des abrasifs est la différence entre les diamètres de particule à 90 % et à 10 % dans une distribution des diamètres de particule cumulative sur base du volume des abrasifs,
dans laquelle les abrasifs comprennent des particules composées de silice, d'alumine, de dioxyde de cérium, de dioxyde de titane, de nitrure de silicium, de carbure de silicium, de nitrure de bore ou de polyméthacrylate de méthyle (PMMA), ou des particules obtenues en liant du polyméthacrylate de méthyle (PMMA) à de la silice.

2. Composition de polissage selon la revendication 1, dans laquelle les abrasifs comprennent de la silice.

3. Composition de polissage selon la revendication 1 ou 2, pour le polissage d'un wafer de silicium.

4. Procédé de polissage d'un wafer de silicium, comprenant le polissage d'un wafer de silicium en utilisant la composition de polissage selon l'une quelconque des revendications 1 à 3.
